Europäisches Patentamt

(19) European Patent Office

Office européen des brevets

(11) Publication number: **0 155 080 B1**

(12) **EUROPEAN PATENT SPECIFICATION**

(45) Date of publication of patent specification: 30.10.91  (51) Int. Cl.⁵: **H05K 7/10**, H01R 43/20

(21) Application number: 85300782.1

(22) Date of filing: 06.02.85

Divisional application 90202185.6 filed on 06/02/85.

(54) Contact for chip carrier and method of inserting same into a housing.

(30) Priority: 27.02.84 US 584274

(43) Date of publication of application:
18.09.85 Bulletin 85/38

(45) Publication of the grant of the patent:
30.10.91 Bulletin 91/44

(84) Designated Contracting States:
**BE CH DE FR GB IT LI NL SE**

(56) References cited:
DE-C- 950 221         FR-A- 2 365 899
FR-A- 2 378 423       FR-A- 2 427 761
US-A- 3 753 211       US-A- 3 910 664

(73) Proprietor: **AMP INCORPORATED**
**P.O. Box 3608 470 Friendship Road**
**Harrisburg Pennsylvania 17105(US)**

(72) Inventor: **Grabbe, Dimitry**
**2160 Rosedale Avenue**
**Middletown Pennsylvania 17057(US)**
Inventor: **Korsunsky, Iosif**
**3971 Dora Drive**
**Harrisburg Pennsylvania 17110(US)**

(74) Representative: **Warren, Keith Stanley et al**
**BARON & WARREN 18 South End Kensington**
**London W8 5BU(GB)**

EP 0 155 080 B1

## Description

This invention relates to a device for connecting a leaded integrated chip carrier package having conductive pads thereon to a circuit board having conductive strips and, more particularly, to a contact for use with chip carrier packages e.g. as known from FR-A-2365 8gg.

With the frequency of chip carrier utilization being on the rise in conjunction with ever-decreasing prices, the use of socket housings to receive the chip carriers has and will continue to take on the same usage and pricing characteristics. However, this results in an increasing demand for less costly material as well as minimizing the amount of material. Further, contact and housing configurations are varied so as to maximize contact mating forces and contribute to ease of manufacturing. Such types of devices may be found, for example, in US-A-4.089,575; US-A- 3,910,664 and US-A-3,753,211.

However, a continuing problem with contact arrangements for chip carrier sockets is that, due to inherently small contact size, handling and therefore insertion into the housings is quite problematic, requiring a reasonably high degree of precision and is generally time-consuming. This is aggravated by the fact that during contact insertion should any contacts become slightly bent or misaligned, contact mating forces may fall below generally acceptable limits. It is generally for this reason, as well as the presence of marginal contact mating forces inherent in small contacts, that gold plating is utilized.

Accordingly, it is desirable to have a device which does not require the handling of small individual parts during insertion into a housing. It is also desirable to have a device which has a contact arrangement which facilitates rapid insertion into its associated housing. Further, it would be advantageous to have a contact which exhibits sufficiently high contact mating forces so that gold is not necessary to achieve optimum electrical characteristics.

The present invention consists in a device for connecting a leaded integrated chip carrier package having conductive pads thereon to a circuit board having conductive strips; the device comprising a chip carrier socket housing and a contact disposed in the housing for providing electrical communication between the conductive pads and the conductive strips through the contact, characterized in that the contact has a first U-shape comprised of a rear beam and a front beam, said rear beam being adjacent the outside wall of the housing and said front beam having a front beam retention portion and a front beam lower portion, wherein said front beam retention portion is askew with respect to said front beam lower portion such that upon insertion of the chip carrier into the housing the front beam retention portion resiliently engages a corresponding conductive pad, said contact further having a second coplanar U-shape which is parallel to and adjacent the base of the first U-shape, wherein the base of the first U-shape forms one arm of the second U-shape, and the second arm of the second U-shape defines an interconnecting area for electrically communicating with the conductive strip.

In order that the present invention may be more readily understood, reference will now be made to the accompanying drawings, in which:-

Figure 1 is an exploded isometric view of a chip carrier, a socket housing and a circuit board with the socket housing embodying the invention;

Figure 2 is a cross-sectional view of the assembled structure of Figure 1 with the chip carrier about to be inserted into the socket housing;

Figure 3 is a cross-sectional view similar to that of Figure 2 with the chip carrier inserted into the socket housing;

Figure 4 is an isometric view of the assembled structure shown in Figure 1;

Figure 5 is an isometric view of the underside of the housing with the contacts about to be inserted therein;

Figure 6 is a view similar to that of Figure 5 showing the contacts about to be separated from their carrier strip; and

Figure 7 is a view similar to that of Figure 6 showing more detail of the feed and cutting mechanism utilized for the insertion of the contacts into the housing.

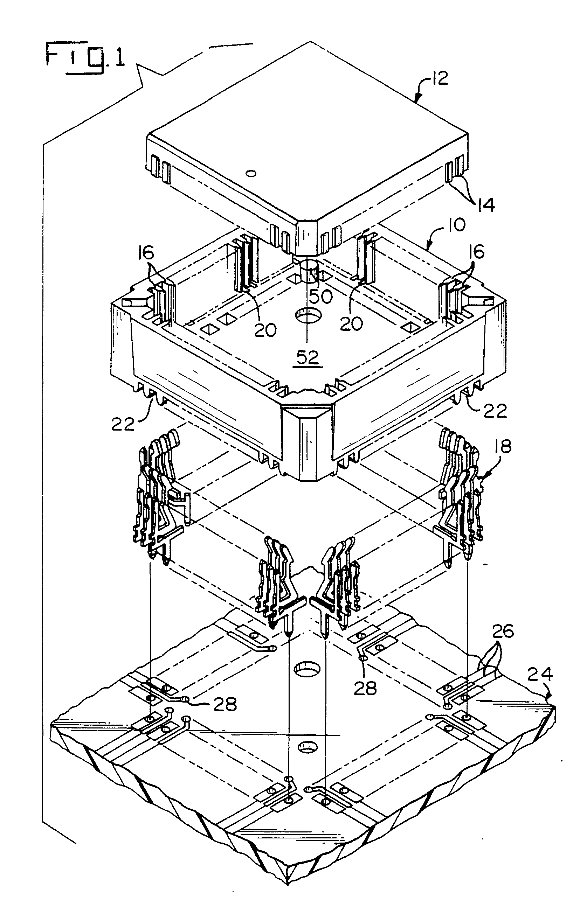

Referring to Figure 1 of the drawings, a contact chip carrier socket housing is shown generally at 10 with a chip carrier 12 shown above the housing 10 which, preferably, is a molded plastic part. The chip carrier 12 has conductive pads or leads 14 thereon and, preferably, the chip carrier 12 is a post molded chip carrier although other types of chip carriers can and may be used.

The housing 10 has contact spacing barriers 16 disposed in the interior which are utilized to separate chip carrier contacts shown generally at 18. The housing 10 has front beam apertures 20 disposed adjacent the spacing barriers 16 and contact lower arm barriers 22 disposed on the underside of the housing 10 which, similar to the spacing barriers 16, provide electrical and physical isolation between adjacent contacts 18. The housing 10 is to be disposed on a circuit board shown generally at 24 with the circuit board having conductive strips 26 thereon and plated holes 28 disposed therein. It is to be understood that, although in the preferred embodiment of the present invention the circuit board 24 is a printed circuit board having plated through holes, other types of circuit boards such as silk-screened can and may be utilized, while plated through holes need not be utilized at all.

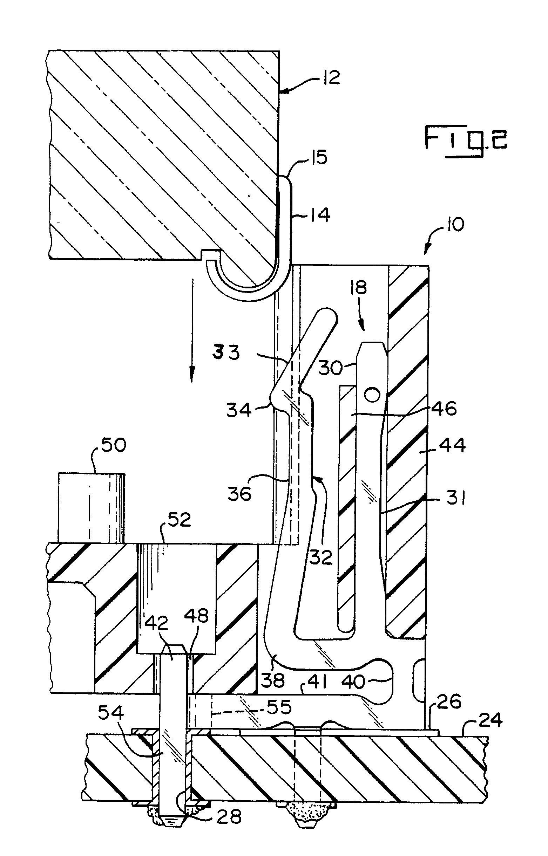

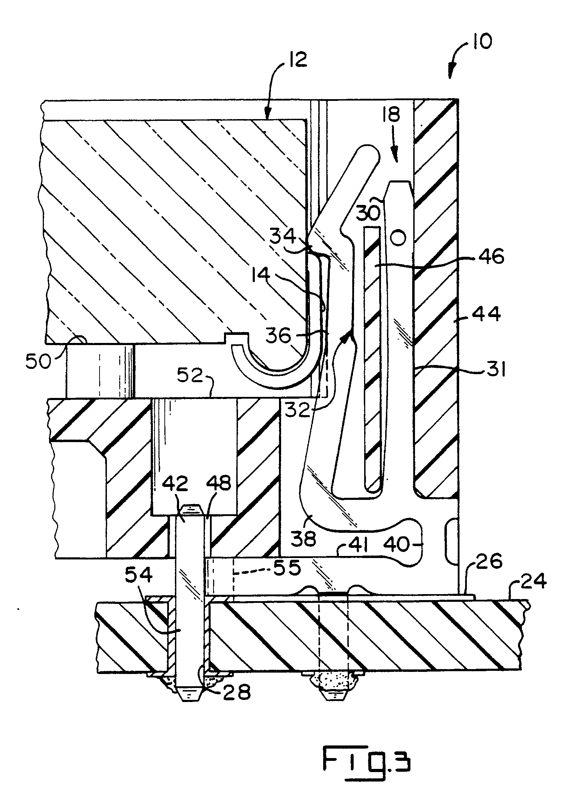

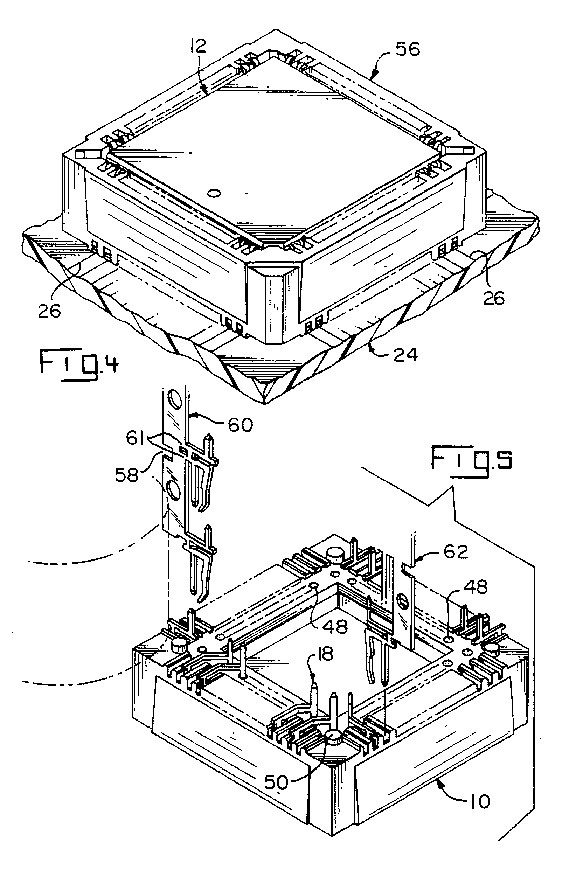

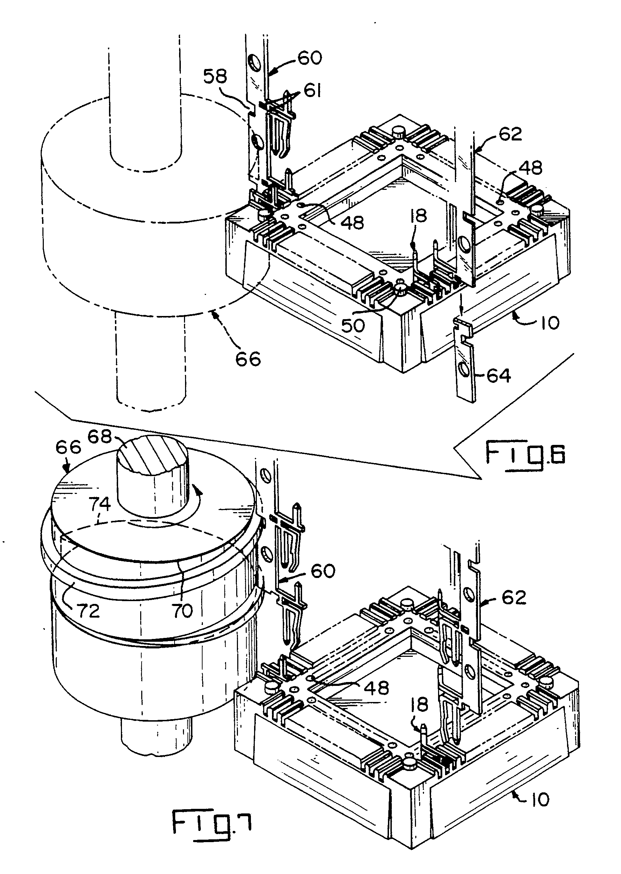

Referring now to Figure 2, a cross-sectional view of the present invention may be seen. The chip carrier 12 as mentioned has conductive pads 14 thereon which are arcuately bent from the side of the chip carrier to the underside thereby forming a conductive pad retention portion 15 at the point where the conductive pad 14 exits the chip carrier 12. The contact housing 10 is comprised of a housing exterior wall 44 and a housing intermediate wall 46 with a chip carrier stop 50 disposed on the housing inner floor 52. The chip carrier contact includes a generally tuning fork type of arrangement or first U-shape having a contact rear arm 30 which has a rear beam flexing portion 31 and a contact front beam 32 having a front beam upper portion 33, a front beam retention portion 34, and a front beam lower portion 36. A front beam pivot elbow 38 provides pivoting motion for the entire contact front beam 32. A contact pivot arm 40 is disposed at the bottom of the tuning fork arrangement for providing isolation between the tuning fork portion and the bottom portion of the contact in order not to transfer a load to the circuit board solder which is particularly important when the present device is surface mounted and is adjacent an interconnection area shown generally at 41 which is utilized for interconnecting the contact 18 to the conductive strip 26. The pivot arm 40 forms the base of a second U-shape of the chip carrier contact, one arm of which is formed by the base of the tuning fork arrangement or first U-shape and the second arm of which is formed by the interconnection area 41. The contact 18 in one arrangement (as shown more fully in Figures 5, 6 and 7) has a contact locating pin 42 which mates with the locating pin aperture 48 disposed in the housing 10. A contact pin 54 is opposite the contact locating pin 42 and is used for mating with a plated through hole disposed in the circuit board 24. As mentioned, since plated through holes may be eliminated, the interconnection area shown generally at 41 may be cut at a surface mount point in the area of 55 which may but does not have to necessitate the removal of contact locating pins such as 42 and contact pins such as 54. In this manner, surface mounting to the circuit board 24 directly to the conductive strips 26 may be utilized.

Referring now to Figure 3, there is shown a cross-sectional view of the present invention mated with a chip carrier. Here it can be readily seen that, upon insertion of the chip carrier 12 into the housing 10 the conductive pad 14 is in a wiping motion mated with the front beam retention portion 34 contained on the contact 18. This thereby removes any oxides or foreign matter which may be present on contacting surfaces. Readily seen is how the conductive pad retention portion 15 engages and slightly pushes up against the front beam retention portion thereby maintaining the chip carrier 12 fixedly in the housing 10. Also, upon insertion of the carrier 12 into the housing 10 the entire contact front beam 32 is caused to move, pivoting about the front beam elbow portion 38 while the contact rear beam 30 is deformed slightly such that the rear beam flexing portion 31 moves and more fully impinges upon the inner surface of the housing exterior wall 44 which in an exaggerated fashion is shown almost completely straightened out. This thereby helps to create and maintain extremely high forces of a contact mating nature between the conductive pads and the contact 18. Therefore, in the preferred embodiment of the present invention, the contacts 18 and the carrier strip associated with them (not shown) are stamped from beryllium copper. In this manner, electrical current may flow through the conductive pad retention portion 15 into the front beam retention portion 34 and thereafter through the front beam lower portion 36 into the lower portions of the contact to the conductive strips 26. This therefore creates an extremely short path so as to minimize any possible capacitive, inductive or resistive effects in the contact's usage.

Referring now to Figure 4, there is shown an assembled and fully mated contact and housing with the chip carrier. Here it can be seen that the chip carrier 12 does not have any type of hold-down bracket which might be used to maintain the chip carrier 12 in the housing 10. Also, the assembled and mated chip carrier and socket 56 does provide access at the top of the housing at the contact spacing barriers for a test probe to perform various testing functions while the chip carrier 12 is in a mated condition while individual contacts may be replaced without disassembly of all the contacts.

Referring now to Figure 5, there is shown the underside of the chip carrier just prior to contact insertion. Here it is readily obvious that two types of carrier strips are utilized for insertion of the contacts of the present invention. A flat contact carrier strip 60 is placed in alternating sequence with the bent or offset contact carrier strip 62. It has been found that the use of these two types of carrier strips allows a staggering effect between adjacent contact pins 54 thereby allowing the pitch or center-to-center spacing to be constructed for high density situations. More precisely, the interconnection area 41 is bent on the bent contact carrier strip 62 while the interconnection area 41 is not bent on the flat contact carrier strip 60. Further, opposite the contact pin 54 is a contact locating pin 42 contained only on the bent contact carrier strip 62. The contact locating pin, as mentioned earlier, is placed into the locating pin aperture 48 disposed and shown on the underside of the housing 10. It has been found that the locating pin and aperture 42, 48 help ensure proper contact pin 54 alignment since the interconnection area 41 for the bent contact carrier strip 62 is longer than the interconnection area 41 contained on the flat contact carrier strip 60. The contacts 18, however, are of the same configuration regardless of the carrier strip with which they are utilized. The carrier strips 60, 62 have an indexing notch 58 regularly spaced along the edge which facilitates manufacture as well as insertion into the housing as will be described below with the contact 18 proper being attached to the carrier strips proper by arms 61. To facilitate insertion of the contacts 18 into the housing 12, the contacts 18 are inserted into the housing from the underside thereof. A feeder/cutter shown generally at 66 is utilized to partially insert the contacts into the housing 12. In the preferred embodiment of the present invention, this is accomplished through the use of two feeder/cutters with one inserting a flat contact carrier strip 60 on the one side of the housing and another inserting a bent contact carrier strip 62 on the opposing of the housing 12. It is to be understood, however, that less than or more than this number of feeder/cutters may be utilized.

Referring now to Figure 6, there is shown the next step for insertion of the contacts 18 into the housing 12. After partial insertion of the contact 18 into the housing 12, the feeder/cutter 66 through rotational movement translates the carrier strips 60, 62 towards the housing. Simultaneously the feeder/cutter 66 removes a portion of the carrier strip proper thereby leaving a discarded carrier strip piece such as shown at 64. Therefore, the contact 18 located close to the housing is almost completely seated into the housing 12 while the adjacent portion of the carrier strip proper is utilized to urge the contact 18 into the housing before itself being cut, with the process then being repeated. After insertion of the contact 18 into the appropriate slot, the housing is then indexed so that, by the time one side of the housing has been inserted in this manner, either a flat or bent contact carrier strip 60, 62 is deposited in every other slot in the housing. At this point the housing in the preferred embodiment of the present invention is rotated 90 degrees so that the adjacent sides are similarly inserted with contacts. After the adjacent sides are similarly inserted, the housing 12 is then rotated once again such that contacts to be inserted are presented to one side already having either flat or bent contact carrier strips 60, 62 deposited with a bent or flat contact carrier strip 62, 60 respectively now ready for insertion into alternating empty slots. Once this side is done, the housing is then rotated once more with the remainder of the contacts being inserted. In this manner, two sets of contacts on opposing sides of the housing are being inserted at all times in a continuous manner.

Referring now to Figure 7, there is shown in greater detail the insertion of contacts into the housing as well as severing of contacts from the carrier strip proper. Shown is the feeder/cutter which is comprised of a mandrel 70 having a center shaft portion 68 with a feeder 72 and a punch or cutter 74 circuitously disposed therearound. The feeder 72 engages the indexing notch 58 contained on the carrier strip and through rotation of the feeder/cutter 66 a contact 18 is inserted into the appropriate slot. Thereafter, through continued rotation of the feeder/cutter 66, the punch or cutter 74 is presented to the carrier strip and, due to the cam-like configuration of the punch or cutter, begins to and finally cuts through the carrier strip. Therefore, during each cycle of the punch or cutter 74, the lower arm of the two arms 61 adjacent the indexing notch 58 is severed with the carrier strip also being cut and the upper arm of the two arms 61 associated with an adjacent contact 18 also being severed. In this manner by adjustment of the rotational speed of the feeder/cutter 66 in conjunction with the indexing done to the housing 10, contacts 18 are inserted in a continuous manner but at no time is a contact 18 handled as an individual piece until after inserted into the housing 10. Upon insertion of all contacts into the housing 10 the contacts 18 are given one last push so as to be fully seated into the housing 10 through the use of an anvil-like operation (not shown) but which is readily known and available to one skilled in the art.

It is to be remembered that many variations of the present invention may be utilized. Such variations may include other types of contact materials such as steel and other types of plated metal such as nickel. Further, the inner or outer beams contained on the contact may be of a slightly different configuration so as to accommodate variations of conductive pads from chip carrier to chip carrier and/or may accommodate different types of housings which may utilize different spacing barriers or means. Also, the housing may be shaped in a rectangular configuration.

Therefore, in addition to the above-enumerated advantages, the disclosed invention produces a contact arrangement for chip carriers as well as a method for inserting them which is relatively inexpensive to utilize as well as manufacture and which eliminates the need for high precision associated with the handling and insertion of individual contacts. Further, the contacts allow for the elimination of gold on contact mating surfaces as well as the elimination of hold-down brackets or covers.

## Claims

1. A device for connecting a leaded integrated chip carrier package (12) having conductive pads (14) thereon to a circuit board (24) having conductive strips (26); the device comprising a chip carrier socket housing (10) and a contact (18) disposed in the housing for providing electrical communication between the conductive pads and the conductive strips through the contact, characterized in that the contact (18) has a first U-shape comprised of a rear beam (30) and a front beam (32), said rear beam being adjacent the outside wall (44) of the housing and said front beam having a front beam retention portion (34) and a front beam lower portion (36), wherein said front beam retention portion is askew with respect to said front beam lower portion such that upon insertion of the chip carrier into the housing the front beam retention portion resiliently engages a corresponding conductive pad, said contact further having a second coplanar U-shape which is parallel to and adjacent the base of the first U-shape, wherein the base of the first U-shape forms one arm of the second U-shape, and the second arm of the second U-shape defines an interconnecting area (41) for electrically communicating with the conductive strip.

2. A device according to claim 1, characterised in that the interconnection area (41) is perpendicular to and in the same plane as the front beam (32) and the rear beam (30), a pivot arm (40) forming the base of said second U-shape interconnects the rear beam and the interconnection area, and electrical communication is established through the front beam, the pivot arm and the interconnection area.

3. A device according to claim 1 or 2, characterised in that the interconnection area is soldered to said conductive strip.

4. A device according to claim 1, 2 or 3, characterised in that a contact pin (54) is attached to the interconnection area for engaging a hole (28) disposed in the circuit board.

## Revendications

1. Dispositif destiné à connecter un boîtier de support de puce intégré avec conducteurs (12) portant des plots conducteurs (14), à une plaquette à circuit (24) comportant des pistes conductrices (26), ce dispositif comprenant un socle femelle (10) pour support de puce et un contact (18) disposé dans le socle pour établir une liaison électrique entre les plots conducteurs et les pistes conductrices par l'intermédiaire du contact, caractérisé en ce que le contact (18) comprend un premier U constitué d'une branche arrière (30) et d'une branche avant (32), la branche arrière étant adjacente à la paroi extérieure (44) du socle et la branche avant comportant une partie de retenue de branche avant (34) et une partie inférieure de branche avant (36), où la partie de retenue de branche avant est oblique par rapport à la partie inférieure de branche avant, de sorte que, lors de l'introduction du support de puce dans le socle, la partie de retenue de branche avant attaque élastiquement un plot conducteur correspondant, le contact comportant, en outre, un second U coplanaire qui est parallèle à la base du premier U et adjacent à celle-ci, la base du premier U formant un bras du second U et le second bras du second U définissant une zone d'interconnexion (41) destinée à être reliée électriquement à la piste conductrice.

2. Dispositif suivant la revendication 1, caractérisé en ce que la zone d'interconnexion (41) est perpendiculaire à la branche avant (32) et à la branche arrière (30) et est dans le même plan que celle-ci, un bras de pivotement (40) formant la base du second U relie la branche arrière et la zone d'interconnexion et la liaison électrique est établie par l'intermédiaire de la branche avant, du bras de pivotement et de la zone d'interconnexion.

3. Dispositif suivant la revendication 1 ou 2, caractérisé en ce que la zone d'interconnexion est brasée à la piste conductrice.

4. Dispositif suivant la revendication 1, 2 ou 3, caractérisé en ce qu'une broche de contact (54) est attachée à la zone d'interconnexion pour engager un trou (28) prévu dans la plaquette à circuit.

## Patentansprüche

1. Vorrichtung zum Verbinden eines mit leitfähigen Kontaktflächen (14) versehenen Chipträgergehäuses (12) für einen integrierten Chip, der mit Anschlüssen versehen (leaded) ist, mit einer Leiterplatte (24), die Leiterbahnen (26) aufweist; wobei die Vorrichtung ein Chipträger-Sockelgehäuse (10) und einen in dem Gehäuse angebrachten Kontakt (18) zum Erzeugen einer elektrischen Verbindung zwischen den Kontaktflächen und den Leiterbahnen über den Kontakt umfaßt,

dadurch gekennzeichnet, daß der Kontakt (18) eine erste U-Form mit einem Hinterschenkel (30) und einem Vorderschenkel (32) aufweist, wobei der Hinterschenkel der Außenwand (44) des Gehäuses benachbart ist und der Vorderschenkel einen Vorderschenkel-Zurückhalteteil (34) sowie einen unteren Vorderschenkelteil (36) aufweist, wobei dabei der Vorderschenkel-Zurückhalteteil gegenüber dem unteren Vorderschenkelteil geneigt ist, so daß beim Einsetzen des Chipträgers in das Gehäuse der Vorderschenkel-Zurückhalteteil federnd an einer entsprechenden Kontaktfläche angreift, wobei der Kontakt ferner eine zweite, in gleicher Ebene liegende U-Form aufweist, die parallel zu der Basis der ersten U-Form verläuft und dieser benachbart ist, wobei die Basis der ersten U-Form einen Schenkel der zweiten U-Form bildet und der zweite Schenkel der zweiten U-Form einen Verbindungsbereich (41) zum elektrischen Verbinden mit der Leiterbahn bildet.

2. Vorrichtung nach Anspruch 1, dadurch gekennzeichnet, daß der Verbindungsbereich (41) senkrecht zu dem Vorderschenkel (32) verläuft und in derselben Ebene wie der Vorderschenkel (32) und der Hinterschenkel (30) liegt, wobei ein die Basis der zweiten U-Form bildender Schwenkarm (40) den Hinterschenkel und den Verbindungsbereich miteinander verbindet, und daß die elektrische Verbindung durch den Vorderschenkel, den Schwenkarm und den Verbindungsbereich hergestellt ist.

3. Vorrichtung nach Anspruch 1 oder 2, dadurch gekennzeichnet, daß der Verbindungsbereich an die Leiterbahn angelötet ist.

4. Vorrichtung nach Anspruche 1, 2 oder 3, dadurch gekennzeichnet, daß ein Kontaktstift (54) zum Eingreifen in ein in die Leiterplatte eingebrachtes Loch (28) an den Verbindungsbereich angebracht ist.

FIG.1

Fig.2

Fig.3

Fig.4

Fig.5

Fig.6

Fig.7